(19) Europäisches Patentamt
European Patent Office
Office européen des brevets

(11) Veröffentlichungsnummer: **0 384 939 B1**

(12) # EUROPÄISCHE PATENTSCHRIFT

(45) Veröffentlichungstag der Patentschrift: **22.06.94**

(21) Anmeldenummer: **89103801.0**

(22) Anmeldetag: **03.03.89**

(51) Int. Cl.$^{5}$: **C08G 59/30**, C08G 59/32, C08G 59/50, H01L 23/29, H01B 3/40

(54) **Epoxidharz-Formmassen.**

(43) Veröffentlichungstag der Anmeldung:
**05.09.90 Patentblatt 90/36**

(45) Bekanntmachung des Hinweises auf die Patenterteilung:
**22.06.94 Patentblatt 94/25**

(84) Benannte Vertragsstaaten:
**AT BE CH DE FR GB LI NL**

(56) Entgegenhaltungen:
**EP-A- 0 271 772**

**CHEMICAL ABSTRACTS, Band 94, Nr. 24, 15. Juni 1981, Seite 37, rechte Spalte, Zusammenfassung Nr. 193199u, Columbus, Ohio, USA; B.M. ZUEV et al.: "Adhesive composition" & USSR 794054**

(73) Patentinhaber: **SIEMENS AKTIENGESELLSCHAFT**
**Wittelsbacherplatz 2**
**D-80333 München(DE)**

(72) Erfinder: **v. Gentzkow, Wolfgang, Dr., Dipl.-Chem.**
**Zwetschgenweg 1**
**D-8524 Kleinsendelbach(DE)**
Erfinder: **Huber, Jürgen**
**Am Heiligenholz 6**
**D-8520 Erlangen(DE)**
Erfinder: **Rogler, Wolfgang, Dr., Dipl.-Chem.**
**Frankenstrasse 44b**
**D-8521 Möhrendorf(DE)**
Erfinder: **Wilhelm, Dieter, Dr., Dipl.-Chem.**
**Bergstrasse 32b**
**D-8550 Forchheim(DE)**

**EP 0 384 939 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

CHEMICAL ABSTRACTS, Band 91, Nr. 6, 6. August 1979, Seite 22, linke Spalte, Zusammenfassung Nr. 40180u, Columbus, Ohio, USA; D.A. KOURTIDES et al.: "Advanced resin matrixes for fire resistant composites" & Annu. Pac. Tech. Conf. Tech. Disp., (Tech. Pap.) (Soc. Plast. Eng.), 1979, Band 4, Seiten 51-54

CHEMICAL ABSTRACTS Band 99, Nr. 26, 26. Dezember 1983, Seite 34, rechte Spalte, Zusammenfassung Nr. 99: 213394n, Columbus, Ohio, USA; V.N. ARTEMOV et al.: "Reactive phosphorus-containing organic compounds as effective fireproofing agents for strong hard-to-burn epoxy polymers" & Plast. Massy, 1983, Nr. 9, Seiten 44-46

CHEMICAL ABSTRACTS Band 106, Nr. 18, 4. Mai 1987, Seite 29, linke Spalte, Zusammenfassung Nr. 139155e, Columbus, Ohio, USA; E.F. GUBANOV et al.: "Phosphorous-containing epoxides and their polymers" & Vysokomol. Soedin., Ser. B, 1987, Band 29, Nr. 1, Seiten 45-47

## Beschreibung

Die Erfindung betrifft Epoxidharz-Formmassen zur Umhüllung von Halbleiterbauelementen sowie aus diesen Formmassen hergestellte Epoxidharz-Formstoffe.

Bauteile für die Elektronik und für die Niederspannungstechnik sind empfindlich gegenüber äußeren Einflüssen und korrosionsanfällig. Zur Sicherung ihrer Funktion müssen diese Bauteile vor ungünstigen Umgebungseinflüssen, wie Feuchtigkeit, aggressive Chemikalien und Staub, sowie vor mechanischer Beschädigung geschützt werden. Dies geschieht heutzutage in der Technik vorwiegend durch Umhüllung oder Einbettung mit härtbaren, d.h. duroplastischen Formmassen, auch Preßmassen genannt. Aufgrund der guten Verarbeitungs- und Formstoffeigenschaften und eines günstigen Preis/Leistungsverhältnisses haben sich Epoxidharz-Formmassen mit Abstand zur führenden Stoffklasse dieses Anwendungsbereiches entwikkelt. Eine Übersicht über Aufbau, Verarbeitungs- und Werkstoffeigenschaften und Anwendung von Epoxidharz-Formmassen findet sich beispielsweise in G.W. Becker und D. Braun "Kunststoffhandbuch", Carl Hanser Verlag München, Wien 1988, Band 10 Duroplaste, Seiten 338 bis 367.

Epoxidharz-Formmassen sind mit anorganischen Füllstoffen hochgefüllte Mischungen von Epoxidharzen mit Härtern, Beschleunigern, Flammschutzmitteln, Gleit- und Trennmitteln, Pigmenten und anderen Zusatzstoffen, wie Flexibilisatoren und Kupplungsreagenzien. Sie werden entweder im Trockenmischverfahren, Schmelzverfahren oder Imprägnierverfahren hergestellt und kommen als staubarmes rieselfähiges Granulat oder in Form von Tabletten in den Handel. Bei der Herstellung und Aufbereitung findet eine Vorreaktion der Harzmischung statt. Für die Handhabung und Weiterverarbeitung der Formmassen ist es wichtig, daß die vorreagierte Mischung einerseits bei tiefen Temperaturen sehr stabil ist, d.h. beispielsweise unterhalb 5 °C über 6 Monate lagerfähig ist, und andererseits bei Verarbeitungstemperatur (ca. 150 bis 180 °C) schnell aufschmilzt, gut fließfähig wird und schnell mit möglichst geringem Reaktionsschrumpf härtet. Derzeit sind bei der Umhüllung elektronischer Bauteile Zykluszeiten von wenigen Minuten zur Entformung realisiert. Es wird jedoch angestrebt, diese Zeit noch weiter zu reduzieren.

Sowohl für die Verarbeitung als auch für die Schutzfunktion der gehärteten Formmassen gilt die Forderung nach möglichst hoher Glasübergangstemperatur $T_G$; sie sollte zumindest über der Werkzeugtemperatur von 150 bis 180 °C liegen, um eine ausreichende Entformungssteifigkeit bei der Formgebung zu gewährleisten. Zum optimalen Schutz der Bauteile sollte die Glasübergangstemperatur höher sein als die höchsten lokal auftretenden Betriebs- und Verarbeitungstemperaturen, weil sich sonst wichtige Eigenschaften des Formstoffes beim Überschreiten der Glasübergangstemperatur sprunghaft verschlechtern. So nimmt beispielsweise die Diffusionsgeschwindigkeit von Feuchtigkeit und anderen Stoffen stark zu, die Dielektrizitätszahl und der Verlustfaktor steigen an und durch Zunahme des Wärmeausdehnungskoeffizienten nimmt die Scherbeanspruchung zwischen Formmasse und Bauteil zu und kann zu Beschädigungen des Bauteils führen. Da beim Lötvorgang eine hohe Temperaturbeanspruchung erfolgt (Lötbadtemperatur: 270 bis 290 °C), sollte $T_G > 200$ °C sein.

Mit zunehmender Miniaturisierung von mikroelektronischen Bauelementen nimmt deren Empfindlichkeit gegenüber mechanischen Spannungen zu, so daß die in herkömmlichen Hüllmassen bei Temperaturänderungen auf die Bauteile ausgeübten Spannungen nicht mehr tolerierbar sind. In jüngerer Zeit sind deshalb sogenannte "low stress"-Preßmassen entwickelt worden, die bei Temperaturwechsel nur noch geringe Kräfte auf die Bauteile ausüben. Erreicht wird dieses "low stress"-Verhalten durch Formmassen-Zusätze, wie Organopolysiloxane oder funktionelle Butadien/Acrylnitril-Polymere, die auch bei niederen Temperaturen ihre flexibilisierende Wirkung beibehalten (siehe: US-PS 4 701 482, JP-OS 62-214650, JP-OS 62-128162).

Für die Schutzfunktion der Formmassen ist es wichtig, daß sie möglichst frei von korrosiven Bestandteilen, wie $Cl^-$, $Br^-$ und $Na^+$, hydrolysierbarem Chlor und $\alpha$-strahlenden Verunreinigungen sind, nach der Härtung eine gute Substrathaftung aufweisen, gegen Feuchtigkeit und organische Lösungsmittel resistent und undurchlässig sind und den mechanischen und thermischen Eigenschaftsanforderungen (Biegefestigkeit $\geqq$ 100 N/mm$^2$, Schlagzähigkeit $\geqq$ 5 Nmm/mm$^2$, linearer Ausdehnungskoeffizient $\alpha \sim 15$ bis $25.10^{-6}$ $K^{-1}$) genügen.

Außerdem müssen die gehärteten Formmassen schwerbrennbar bzw. selbstverlöschend sein und eine der härtesten Materialprüfnormen bestehen, nämlich die Brennprüfung nach UL 94V mit einer V-O-Einstufung. Bei dieser Prüfung werden je fünf vertikal gehalterte Normprüfkörper zweimal je 10 s am unteren Ende beflammt. Die Summe der zehn bis zum Verlöschen gestoppten Nachbrennzeiten muß < 50 s sein und kein Einzelwert darf 10 s überschreiten. Diese Forderung ist schwer zu erfüllen, vor allem bei dünnen Wandstärken von 1,6 mm und darunter, wie dies in der Elektronik üblich ist.

Im technischen Einsatz befindliche Epoxidharz-Formmassen erfüllen diese Forderungen nur, weil sie bis zu 80 % unbrennbare anorganische Füllstoffe enthalten und der verbleibende Reaktionsharzanteil durch erhebliche Anteile an kernbromierten aromatischen Komponenten oder Additiven und hohe Konzentrationen

an Antimontrioxid schwerbrennbar ausgerüstet wird. Die Problematik bei diesen Verbindungen besteht darin, daß sie einerseits zwar als Flammschutzmittel hervorragend wirksam sind, andererseits aber auch sehr bedenkliche Eigenschaften besitzen. So steht Antimontrioxid auf der Liste der krebserregenden Chemikalien, und aromatische Bromverbindungen spalten bei der thermischen Zersetzung nicht nur Bromradikale und Bromwasserstoff ab, die zu starker Korrosion führen, bei der Zersetzung in Gegenwart von Sauerstoff können insbesondere die hochbromierten Aromaten vielmehr auch die hochtoxischen Polybromdibenzofurane und Polybromdibenzodioxine bilden. Erhebliche Schwierigkeiten bereitet desweiteren die Entsorgung von bromhaltigen Altwerkstoffen und Giftmüll.

Die im technischen Einsatz befindlichen Epoxidharz-Formmassen haben zwar ein sehr gutes Verarbeitungsverhalten, sie erreichen aber nach der Härtung nur eine Glasübergangstemperatur im Bereich von 150 bis 180 ° C. Materialien, die die Forderung nach erhöhter Wärmebeständigkeit erfüllen, sind Formmassen auf Polyimidbasis. Aufgrund des erheblich höheren Materialpreises und ihres schlechten Verarbeitungsverhaltens, das höhere Härtungstemperaturen und längere Härtungszeiten erfordert, bleibt der technische Einsatz derartiger Formmassen aber auf Spezialanwendungen beschränkt. Als mögliche Alternative zu den im technischen Einsatz befindlichen Epoxidharzen werden Kombinationen aus Maleinimiden mit Alkenylphenolen und/oder Alkenylphenolethern (DE-OS 26 27 045), aus Maleinimiden, Polyallylphenolen und Epoxidharzen (JP-OS 53-134099) oder Kombinationen aus Alkenylaryloxygruppen-haltigen s-Triazin-Verbindungen und Polymaleinimiden (EP-OS 0 263 915) diskutiert.

Ein vergleichsweise kostengünstiges Harzsystem wird erhalten, wenn aromatische und/oder heterocyclische Polyepoxidharze, d.h. Polyglycidylverbindungen, mit aromatischen Polyaminen als Härter kombiniert werden. Derartige Polyamine, die beispielsweise aus der DE-PS 27 43 680 bekannt sind, führen zu besonders wärmeformbeständigen, alterungsstabilen Netzwerkpolymeren. Der EP-OS 0 271 772 ist zu entnehmen, daß bei Verwendung von 1.3.5-Tris(3-amino-4-alkylphenyl)-2.4-6-trioxo-hexahydrotriazinen als Härter Formstoffe erhalten werden, die Glasübergangstemperaturen bis 245 ° C aufweisen und sich durch ein gutes Ver- und Bearbeitungsverhalten auszeichnen.

Für alle genannten Harzsysteme gilt der Nachteil, inhärent nicht ausreichend schwerbrennbar zu sein. Zur Erfüllung der für die Elektronik unverzichtbaren Forderung, die Brandprüfung nach UL 94V mit der Einstufung V-O zu bestehen, kann deshalb auf den Einsatz von hochwirksamen bromhaltigen Flammschutzmitteln und Antimontrioxid nicht verzichtet werden (siehe: DE-OS 27 00 363). Dies hat zur Folge, daß einerseits das mit Bromverbindungen und Antimontrioxid verbundene Gefährdungspotential und andererseits eine durch die Bromverbindungen hervorgerufene Verschlechterung des thermisch-mechanischen Eigenschaftsniveaus in Kauf genommen werden muß. Es ist nämlich bekannt, daß der Zusatz kernbromierter Aromaten eine Reduzierung der Glasübergangstemperatur bewirkt. So wurde beispielsweise gefunden, daß die Glasübergangstemperatur von Polyimiden durch Zugabe von Bromverbindungen um 40 bis 70 ° C reduziert wird (siehe: "Polymer Journal", Vol. 20 (1988), Seiten 125 ff.). Bei den in der EP-OS 0 271 772 beschriebenen Systemen aus Epoxiden und Polyaminen wird bei teilweisem Ersatz der Epoxidkomponente durch die entsprechende bromierte Verbindung, entsprechend einem Gesamtbromgehalt von 4 %, eine Reduktion der $T_G$ um ca. 50 ° C auf Werte von unter 200 ° C gefunden.

Aus diesen Gründen hat es nicht an Versuchen gefehlt, die bromhaltigen Flammschutzmittel in Reaktionsharzsystemen durch weniger problematische Substanzen zu ersetzen. So wurden beispielsweise Füllstoffe mit Löschgaswirkung, wie Aluminiumoxidhydrate (siehe: "J. Fire and Flammability", Vol. 3 (1972), Seiten 51 ff.), basische Aluminiumcarbonate (siehe: "Plast. Engng.", Vol. 32 (1976), Seiten 41 ff.) und Magnesiumhydroxide (EP-OS 0 243 201), sowie verglasende Füllstoffe, wie Borate (siehe: "Modern Plastics", Vol. 47 (1970), Seiten 140 ff .) und Phosphate (US-PS 2 766 139 und 3 398 019), vorgeschlagen. Allen diesen Füllstoffen haftet aber der Nachteil an, daß sie die mechanischen, chemischen und elektrischen Eigenschaften der Formstoffe zum Teil erheblich verschlechtern.

Es ist auch schon die flammhemmende Wirksamkeit von rotem Phosphor beschrieben worden (GB-PS 1 112 139), gegebenenfalls in Kombination mit feinstverteiltem Siliciumdioxid oder Aluminiumoxidhydrat (US-PS 3 373 135). Dabei werden Formstoffe erhalten, die - wegen der unter ungünstigen Bedingungen eventuell entstehenden Phosphorsäure und der damit verbundenen Korrosion - den Einsatz für elektrotechnische und elektronische Zwecke einschränken. Desweiteren wurden bereits organische Phosphorverbindungen, wie Phosphorsäureester, Phosphonsäureester und Phosphine, als flammhemmende Additive vorgeschlagen (siehe: W.C. Kuryla und A.J. Papa "Flame Retardancy of Polymeric Materials", Vol. 1, Seiten 24 bis 38 und 52 bis 61, Marcel Dekker Inc., New York, 1973). Da diese Verbindungen für ihre "weichmachenden" Eigenschaften bekannt sind und als Weichmacher für Polymere weltweit in großem Maßstab verwendet werden (GB-PS 10 794) ist auch diese Alternative hinsichtlich der geforderten Wärmebeständigkeit von Formstoffen wenig erfolgversprechend.

Eine wirksamere Möglichkeit zur schwerbrennbaren Einstellung von Epoxidharzen besteht darin, im Polymernetzwerk verankerbare Phosphorverbindungen, wie epoxidgruppenhaltige Phosphorverbindungen, einzusetzen. Die thermisch-mechanischen Eigenschaften der in diesem Fall bei der Härtung erhaltenen Formstoffe sind jedoch nicht ausreichend. So werden beispielsweise bei der aminischen Härtung von Epoxidharzen aus Methyl-diglycidyl-phosphonat und Dicarbonsäuren Formstoffe mit einer $T_G$ von 45 bis 80 °C erhalten (siehe: "Vysokomol. Soedin.", Ser. B. 29 (1), Seiten 45 bis 47 (1987)). Dies stimmt mit der Erfahrung überein, daß Phosphorsäureestergruppierungen, sowohl in der Polymerhauptkette als auch in der Seitenkette, grundsätzlich eine Weichmachung und damit eine Senkung der Glasübergangstemperatur bewirken (siehe: "Journal of Macromolecular Science", Vol. Cl, No. 1 (1967), Seiten 3 ff.). Außerdem ist ein Großteil dieser Verbindungen flüssig oder kristallin und kommt deshalb für die schwerbrennbare Einstellung von Epoxidharzen nicht in Frage, da sie entweder den Erweichungspunkt der Festharze stark herabsetzen, Klebrigkeit bewirken oder - im Falle von kristallinen Verbindungen - wieder auskristallisieren (siehe: DE-OS 25 38 675). Epoxidgruppenhaltige Phosphorverbindungen werden deshalb in allen bekannten Arbeiten zunächst in einer Vorreaktion mit Bisphenolen oder Phenolharzen (DE-OS 25 38 675 und JP-OS 58-185631), mit Dicarbonsäuren (siehe: "Vysokomol. Soedin.", Ser. B. 29 (1), Seiten 45 bis 47 (1987)) oder mit Polyesterharzen aus Dihydroxyverbindungen und Dicarbonsäuren (JP-OS 50-043221) umgesetzt und erst dann in Mischung mit den Epoxidharzen - überwiegend ionisch - gehärtet. Die dabei erreichte Schwerbrennbarkeit ist allerdings gering. So werden beispielsweise an Harzen, die durch eine Vorreaktion mit Bisphenolen erhalten werden, LOI-Werte (Limiting Oxygen Index) von 23,5 bis 24 erreicht (siehe: DE-OS 25 38 675), d.h. Werte, wie man sie bei durchaus brennbaren Materialien, wie Wolle (LOI = 25), findet, während die LOI-Werte für bekanntermaßen schwerbrennbare Materialien, wie Polysulfon (LOI = 30), Polyvinylchlorid (LOI = 42), Polyvinylidenchlorid (LOI = 60) und Polytetrafluorethylen (LOI = 95), wesentlich höher liegen (siehe: D.W. v. Krevelen "Properties of Polymers", Elsevier Scientific Publishing Comp. Amsterdam, Oxford, New York, 1976, Seiten 526 ff.). Im Falle der Umsetzungsprodukte von Polyesterharzen mit Triglycidylphosphaten (siehe: JP-OS 50-043221) müssen zur schwerbrennbaren Einstellung von Polyesterfasern sogar Halogenverbindungen und Antimontrioxid hinzugegeben werden.

Aufgabe der Erfindung ist es, Epoxidharz-Formmassen anzugeben, die kostengünstig zugänglich und vergleichbar den im technischen Einsatz befindlichen Epoxidharz-Formmassen verarbeitbar sind und - ohne Zusatz von Halogenverbindungen oder Antimontrioxid - schwerbrennbare, d.h. entsprechend UL 94V nach V-O einstufbare Formstoffe mit einer möglichst hohen Glasübergangstemperatur ( > 200 °C) und einem möglichst geringen thermischen Ausdehnungskoeffizienten (~ 15 bis $25.10^{-6}$ $K^{-1}$) liefern.

Dies wird erfindungsgemäß dadurch erreicht, daß die EpoxidharzFormmassen folgende Komponenten enthalten:

(A) ein phosphorfreies aromatisches und/oder heterocyclisches Polyepoxidharz, gegebenenfalls in Abmischung mit einem aliphatischen Epoxidharz,

(B) eine epoxidgruppenhaltige Phosphorverbindung folgender Struktur:

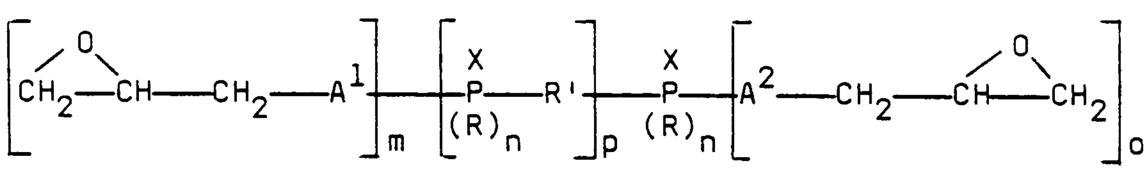

mit m = 0 oder 1, n = 0, 1 oder 2 und o = 1, 2 oder 3, wobei folgendes gilt: m + n + o = 3, und mit p = 0, 1 oder 2;

X bedeutet ein freies Elektronenpaar oder ein über eine Doppelbindung gebundenes O- oder S-Atom,

R bedeutet einen direkt oder über O oder S gebundenen Alkylrest mit 1 bis 4 C-Atomen, Alkenylrest mit 2 bis 3 C-Atomen, Arylrest, wie Phenyl, Alkoxyphenyl, Nitrophenyl, Naphthyl und Biphenyl, Aralkylrest, wie Benzyl, Dialkylamino- oder Alkylarylaminorest oder 3-Trialkylsilyl-propylrest,

R′ bedeutet eine Brücke aus O, S, Phenylen, Dioxyphenylen, Dioxynaphthylen, $(CH_2)_r$, O-$(CH_2)_r$, O-$(CH_2)_r$-O oder O-$(CH_2)_r$-$(Si(CH_3)_2$-$O)_s$-$Si(CH_3)_2(CH_2)_r$-O mit r = 1 bis 3 und s = 1 bis 8, oder (O-$CH_2$-$CH_2)_t$-O, (O-$CH(CH_3)$-$CH_2)_t$-Ooder (O-$(CH_2)_4)_t$-O mit t = 2 bis 100, und

$A^1$ und $A^2$, die gleich oder verschieden sein können, bedeuten eine Einfachbindung oder eine Brücke entsprechend der Gruppierung R′;

(C) ein aromatisches Polyamin folgender Struktur als Härter:

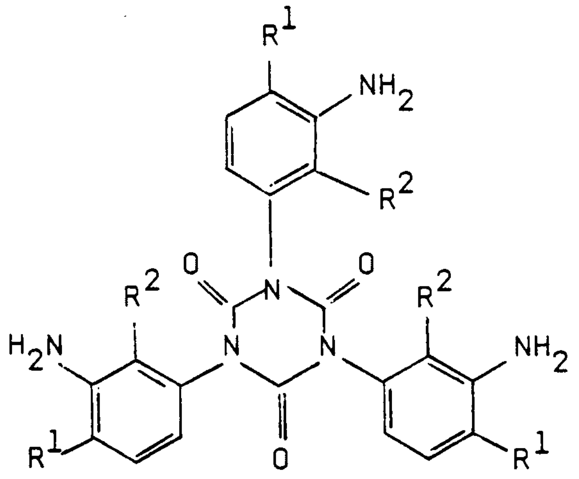

,

wobei an jeder der drei aromatischen Partialstrukturen jeweils einer der Reste $R^1$ und $R^2$ H und der andere Alkyl bedeutet; und

(D) Füllstoffe.

Es wurde nämlich völlig überraschend gefunden, daß bei Verwendung einer Kombination aus Komponenten der vorstehend genannten Art, d.h. aus (phosphorfreien) aromatischen und/oder heterocyclischen Polyepoxidharzen, epoxidgruppenhaltigen Phosphorverbindungen, Polyaminen (als Härter) und Füllstoffen, sowohl die Schwerbrennbarkeit als auch die mechanische Festigkeit der daraus erhaltenen Reaktionsharzformstoffe deutlich gesteigert wird. Es wurde außerdem überraschend gefunden, daß sich die erfindungsgemäße Kombination aus den Komponenten (A), (B), (C) und (D) kostengünstig und vergleichbar oder sogar besser als die im technischen Einsatz befindlichen Epoxidharze verarbeiten läßt. Die im Stand der Technik als notwendig beschriebene Vorreaktion flüssiger oder kristalliner epoxidgruppenhaltiger Phosphorverbindungen mit Bisphenolen oder Dicarbonssäuren ist somit nicht erforderlich.

Als Polyepoxidharz, d.h. Polyglycidylverbindung, eignen sich insbesondere folgende Verbindungen: aromatische Polyglycidylether, wie Bisphenol-A-diglycidylether, Bisphenol-F-diglycidylether und Bisphenol-S-diglycidylether, Polyglycidylether von Phenol/Formaldehyd-Harzen und Kresol/Formaldehyd-Harzen, Resorcindiglycidylether und Tetrakis(p-glycidylphenyl)-ethan, Dibzw. Polyglycidylester von Phthal-, Isophthal- und Terephthalsäure sowie von Trimellithsäure, N-Glycidylverbindungen von aromatischen Aminen und heterocyclischen Stickstoffbasen, wie N.N-Diglycidylanilin, N.N.O-Triglycidyl-p-aminophenol, Triglycidylisocyanurat und N.N.N'.N' -Tetraglycidyl-bis(p-aminophenyl)-methan, Hydantoin-Epoxidharze und Uracil-Epoxidharze sowie Di- und Polyglycidylverbindungen von mehrwertigen aliphatischen Alkoholen, wie 1.4-Butandiol, Trimethylolpropan und Polyalkylenglykolen. Desweiteren sind als Komponente (A) auch modifizierte Epoxidharze geeignet, beispielsweise oxazolidinonmodifizierte Epoxidharze. Derartige Verbindungen sind bereits bekannt (siehe: "Angew. Makromol. Chem.", Bd. 44 (1975), Seiten 151 bis 163, sowie US-PS 3 334 110); beispielhaft sei hierfür das Umsetzungsprodukt von Bisphenol-A-diglycidylether mit Diphenylmethandiisocyanat (in Gegenwart eines geeigneten Beschleunigers) genannt. Als weitere Beispiele für modifizierte Epoxidharze seien die Umsetzungsprodukte von Epoxidharzen mit aminmodifizierten Bismaleinimiden genannt. Die Polyepoxidharze können in den erfindungsgemäßen Epoxidharz-Formmassen einzeln oder im Gemisch vorliegen. Bevorzugt wird als Polyepoxidharz ein epoxidierter Novolak verwendet.

Auch die Komponente (B) kann sowohl in Form einzelner Verbindungen als auch in Form eines Gemisches mehrerer Verbindungen zum Einsatz gelangen. Als Komponente (B) eignen sich beispielsweise folgende epoxidgruppenhaltige Phosphorverbindungen, die sämtlich bereits bekannt sind: Methyl-diglycidyl-phosphonat, Ethyl-diglycidyl-phosphonat, Propyl-diglycidyl-phosphonat, Butyl-diglycidyl-phosphonat, Vinyl-diglycidyl-phosphonat, Phenyl-diglycidyl-phosphonat und Biphenyl-diglycidyl-phosphonat; Methyl-diglycidyl-phosphat, Ethyl-diglycidyl-phosphat, n-Propyl-diglycidyl-phosphat, n-Butyl-diglycidyl-phosphat, Isobutyldiglycidyl-phosphat, Allyl-diglycidyl-phosphat, Phenyl-diglycidyl-phosphat, p-Methoxyphenyl-diglycidyl-phosphat, pEthoxyphenyl-diglycidyl-phosphat, p-Propyloxyphenyl-diglycidylphosphat, p-Isopropyloxyphenyl-diglycidyl-phosphat, Phenylthiodiglycidyl-phosphat, Triglycidyl-phosphat, Tris(glycidylethyl)phosphat, p-Glycidylphenyl-ethyl-glycidyl-phosphat und Benzyldiglycidyl-thiophosphat.

Die Synthese dieser Verbindungen erfolgt beispielsweise durch Umsetzung von Phosphonsäure- oder Phosphorsäurechloriden mit Glycidol (siehe: "Zh. Obshch. Khim.", Bd. 54, Heft 10 (1984), Seiten 2404 ff.), durch Umsetzung von Phosphorsäure oder Phosphonsäuren mit Epichlorhydrin (JP-OS 51-143620) oder durch Epoxidierung von Phosphorverbindungen, die Reste mit olefinischen Doppelbindungen enthalten (US-PS 2 856 369).

Das Mischungsverhaltnis der Komponenten (A) und (B) läßt sich - entsprechend dem gewünschten Eigenschaftsspektrum - in einem breiten Bereich variieren. Für gewisse Anwendungen ist es sogar möglich, auf die Komponente (A) ganz zu verzichten. Vorteilhaft beträgt das Mischungsverhältnis von (A) zu (B) bei den erfindungsgemäßen Epoxidharz-Formmassen 10:1 bis 1:10 und vorzugsweise 4:1 bis 1:4, insbesondere 2:1 bis 1:2.

Die in den erfindungsgemäßen Epoxidharz-Formmassen als Härter dienenden aromatischen Polyamine sind zum Teil bereits bekannt. Polyamine der angegebenen Struktur mit $R^1$ = Alkyl und $R^2$ = H sind in der EP-OS 0 271 772 beschrieben. Sie werden durch Trimerisierung von 2.4-Diisocyanato-alkylbenzolen und nachfolgende Hydrolyse der verbleibenden Isocyanatgruppen hergestellt. Verbindungen mit $R^1$ = H und $R^2$ = Alkyl werden analog durch Trimerisierung von 2.6-Diisocyanato-alkylbenzolen und nachfolgende Hydrolyse erhalten. Als Komponente (C) können in den erfindungsgemäßen Epoxidharz-Formmassen sowohl Polyamine der beiden vorstehend genannten Arten als auch Gemische dieser Verbindungen verwendet werden. Darüber hinaus können auch Polyamine eingesetzt werden, die durch Trimerisierung von Gemischen aus 2.4- und 2.6-Diisocyanato-alkylbenzolen und nachfolgende Hydrolyse der Trimerisate erhalten werden. Derartige Gemische sind großtechnisch zugänglich und erlauben eine kostengünstige Herstellung der Härterkomponente.

Bei der Hydrolyse der isocyanatgruppenhaltigen Trimerisierungsprodukte kann es auch zu einer Reaktion zwischen Isocyanatgruppen und Aminogruppen kommen. Dabei werden, als Nebenprodukt der Hydrolysereaktion, heterocyclische Polyamine mit Harnstoffgruppierungen erhalten. Derartige Polyamine können in den erfindungsgemäßen Epoxidharz-Formmassen als additive Härterkomponente eingesetzt werden, d.h. im Gemisch mit dem eigentlichen Härter zum Einsatz gelangen. Neben dem eigentlichen Härter bzw. neben Härtergemischen der vorstehend genannten Art können in den Epoxidharz-Formmassen auch aromatische Polyamine anderer Art, wie 4.4'-Diaminodiphenylmethan und 4.4'-Diaminodiphenylsulfon, und/oder andere heterocyclische Polyamine eingesetzt werden. Der Anteil derartiger Polyamine im Härtergemisch beträgt im allgemeinen maximal 30 Masse-%.

Das Verhältnis zwischen eingesetzter Epoxid-Funktion (Komponenten A und B) und eingesetzter Aminwasserstoff-Funktion NH (Komponente C) kann bei den erfindungsgemäßen Epoxidharz-Formmassen 0,9:1 bis 1,5:1 betragen, vorteilhaft beträgt es 0,9:1 bis 1,1:1 und vorzugsweise etwa 1:1.

Als Füllstoffe dienen in den erfindungsgemäßen Epoxidharz-Formmassen pulverförmige anorganische und/oder organische Stoffe. Diese Füllstoffe können auch im Gemisch mit anorganischen und/oder organischen Kurzfasern, beispielsweise in Form von Textilglas-Kurzfasern, zum Einsatz gelangen. Textilglas-Kurzfasern weisen - entsprechend DIN 61850 - eine Faserlänge unter 1 mm auf; die mittlere Faserlänge beträgt vorzugsweise etwa 0,2 mm. Als anorganische Füllstoffe dienen insbesondere mineralische Füllstoffe, die mit oder ohne Haftvermittler verwendet werden können. Derartige Füllstoffe sind Carbonate, wie Dolomit, beispielsweise in Form von Microdol$^R$, sowie Aluminiumoxide und -oxidhydrate. Bevorzugt dienen als Füllstoffe $\alpha$-strahlungsarme Mehle aus Quarz oder Quarzgut, insbesondere aus $\alpha$-strahlungsarmen Rohstoffen, wie Bergkristall, sowie Siliciumdioxid ($SiO_2$) mit geringer $\alpha$-Aktivität, wie es beispielsweise aus der DE-OS 33 23 844 bekannt ist. Derartiges Siliciumdioxid ist frei von Verunreinigungen, insbesondere von den für die $\alpha$-Emission verantwortlichen Elementen Thorium und Uran; es weist deshalb Emissionsraten $<$ 0,01 $\alpha$-Teilchen/$cm^2$.h auf. Als organische Fasern können beispielsweise Aramid- und Polyphenylensulfid-Fasern eingesetzt werden.

Der Füllstoffanteil beträgt in den erfindungsgemäßen Epoxidharz-Formmassen im allgemeinen 50 bis 85 Masse-%; vorzugsweise beträgt dieser Anteil 60 bis 80 Masse-%. Enthält der Füllstoff - neben pulverförmigen mineralischen Stoffen - auch Textilglas-Kurzfasern, so beträgt der Faseranteil im Füllstoffgemisch vorzugsweise 3 bis 40 Masse-%. Als Füllstoffe kommen, allein oder im Gemisch mit anderen mineralischen Füllstoffen, auch faserige Füllstoffe auf mineralischer Basis in Betracht, beispielsweise Calciumsilicate, wie Wollastonit.

Die Aufbereitung der erfindungsgemäßen Epoxidharz-Formmassen kann in der Weise erfolgen, daß die Komponenten (A), (B), (C) und (D) auf geeigneten Mischeinrichtungen, wie einem Walzenstuhl, direkt miteinander vermischt werden (sogenannte trockene Aufbereitung). Es kann jedoch auch in der Weise vorgegangen werden, daß die Füllstoffe in eine Lösung von (A), (B) und (C) in einem geeigneten organischen Lösungsmittel eingebracht werden (sogenannte nasse Aufbereitung). Derartige Lösungsmittel sind beispielsweise Aceton, Ethylacetat, Methylethylketon und Methylglykol (2-Methoxyethanol), wobei

insbesondere ketonische Lösungsmittel zum Einsatz gelangen, vorzugsweise Aceton. Die Lösungen weisen dabei vorzugsweise einen Gehalt von 40 bis 60 Masse-% der Komponenten (A), (B) und (C) auf. Nach dem Einbringen der Füllstoffe und dem Vermischen wird das Lösungsmittel im Vakuum entfernt, beispielsweise bei einem Druck von 1 mbar und einer Temperatur von 60 °C.

Die erfindungsgemaßen Epoxidharz-Formmassen weisen bei Raumtemperatur mit mehr als 6 Monaten eine höhere Lagerstabilität auf als die derzeit im technischen Einsatz befindlichen Formmassen. Innerhalb dieser Zeit ist eine einwandfreie Verarbeitbarkeit gewährleistet; bei Temperaturen oberhalb 150 °C erfolgt dagegen eine rasche Vernetzung. Die erfindungsgemäßen Formmassen zeichnen sich ferner durch einen geringen Reaktionsschwund aus. Im ubrigen können die erfindungsgemäßen Formmassen - zusätzlich zu den genannten Komponenten - weitere Zusatzstoffe, wie Beschleuniger, Gleit- und Trennmittel, Pigmente, Flexibilisatoren, Kupplungsreagentien und Stabilisatoren, enthalten.

Die erfindungsgemaßen Epoxidharz-Formmassen werden im allgemeinen nach üblichen Transferpreßverfahren verarbeitet, d.h. sie werden unter erhöhtem Druck und erhöhter Temperatur verpreßt. Technisch wird dabei heutzutage bevorzugt mit Multiplungers mit Mehrfachformen gearbeitet. Bei Temperaturen oberhalb 150 °C werden diese Formmassen dann in einer rasch verlaufenden Vernetzungsreaktion in die entsprechenden Formstoffe übergeführt.

Die aus den erfindungsgemäßen Epoxidharz-Formmassen hergestellten Epoxidharz-Formstoffe weisen neben einer hohen Glasübergangstemperatur ($T_G$ > 200 °C) einen niedrigen linearen Wärmeausdehnungskoeffizienten auf, und zwar im Temperaturbereich von Raumtemperatur bis über 200 °C; der Wärmeausdehnungskoeffizient liegt - abhängig von Füllstoffart und Füllstoffgehalt - im Bereich von 15 bis $25.10^{-6}$ $K^{-1}$. Wegen des fehlenden $\alpha$-Sprungs im genutzten Temperaturbereich werden verringerte Spannungen auf das Gesamtsystem ausgeübt. Durch geeignete Wahl der Reste R′, $A^1$ und $A^2$ der Komponente (B) werden diese Spannungen noch weiter reduziert. Die erfindungsgemäßen Formstoffe sind außerdem selbstverlöschend: Mit einer mittleren Brenndauer von $\ll$ 5 s wird die Brennprüfung nach UL 94V - ohne Zusatz von Halogenverbindungen oder sonstigen flammhemmenden Zusatzstoffen - selbst bei Prüfkörpern mit einer Wandstärke ≦ 1,6 mm mit einer sicheren V-O-Einstufung bestanden. Dabei erweist es sich als besonders vorteilhaft, daß sich keine korrosiven oder besonders toxischen Spaltprodukte bilden, und daß die Rauchentwicklung im Vergleich zu anderen Polymerwerkstoffen, insbesondere zu bromhaltigen Epoxidharz-Formstoffen, stark vermindert ist.

Die ausgehärteten Formstoffe zeichnen sich ferner durch hohe Chemikalienbeständigkeit, Korrosionsbeständigkeit, geringe Wasseraufnahme und sehr gute elektrische Eigenschaftswerte aus. Ferner zeigen diese Formstoffe eine gute Haftfestigkeit auf Metallen, was bei der Umhüllung von Halbleiterbauelementen sehr wichtig ist, und darüber hinaus wird dabei die Dichtigkeit der Beinchen ("pins") gegenüber eindringender Feuchtigkeit gewährleistet.

Anhand von Ausführungsbeispielen soll die Erfindung noch näher erläutert werden.

Beispiel 1: Herstellung von Formmassen

a) Nasse Aufbereitung (Aufbereitung in einem Lösungsmittel)

Eine Lösung von A Masseteilen (MT) eines epoxidierten Novolaks (mit einem Epoxidwert von 0,57) in B Masseteilen Aceton wird mit einer Lösung von C Masseteilen eines Polyamins, das durch Trimerisierung einer 4:1-Mischung aus Toluol-2.4-diisocyanat und Toluol-2.6-diisocyanat und nachfolgende Hydrolyse zu einem Produkt mit einem $NH_2$-Wert von 8,7 % hergestellt wurde, in D Masseteilen Aceton und mit E Masseteilen Phenyl-diglycidylphosphonat (zur Herstellung siehe: "Zh. Obshch. Khim.", Bd. 54, Heft 10 (1984), Seiten 2404 ff.) versetzt. Die Zusammensetzung verschiedener Mischungen ist Tabelle 1 zu entnehmen. Diese Mischungen werden mit F Masseteilen Quarzgutmehl, beispielsweise Silbond FW 12 EST (Fa. Quarzwerke GmbH), versetzt und gemischt. Die Gemische werden dann auf eine Aluminiumfolie ausgegossen und dann wird das Lösungsmittel in einem Vakuumtrockenschrank entfernt (Druck: 1 mbar; Temperatur: 60 °C; Dauer: 30 min). Die dabei erhaltenen rieselfähigen Massen sind bei Raumtemperatur mindestens 6 Monate und bei 5 °C noch wesentlich länger lagerstabil und übertreffen somit die Lagerfähigkeit der derzeit technisch eingesetzten Formmassen deutlich.

b) Trockene Aufbereitung

A Masseteile eines epoxidierten Novolaks (mit einem Epoxidwert von 0,57) werden mit C Masseteilen eines Polyamins, das wie vorstehend beschrieben hergestellt wurde ($NH_2$-Wert: 8,7 %) E Masseteilen Phenyl-diglycidyl-phosphonat und F Masseteilen Quarzgutmehl, beispielsweise Silbond FW 12 EST, versetzt und auf einem Walzenstuhl 30 min lang durchgemischt (Walzentemperatur: 30 bis 60 °C). Die jeweiligen Masseteile sind Tabelle 1 zu entnehmen. Dabei werden rieselfähige Massen erhalten, die bei Raumtemperatur mehr als 6 Monate und bei 5 °C noch wesentlich länger lagerstabil sind und somit die Lagerfähigkeit der derzeit technisch eingesetzten Formmassen deutlich übertreffen.

Tabelle 1

| Versuchs-Nr. | 1 | 2 | 3 | 4 | 5 |
|---|---|---|---|---|---|
| Walzentemperatur (°C) | 60 | 50 | 40 | 30 | 30 |
| Komponenten: | | | | | |
| A (MT) | 66 | 48 | 42 | 34 | 0 |
| B (MT) | 66 | 48 | 42 | 34 | 0 |
| C (MT) | 34 | 36 | 36 | 36 | 40 |
| D (MT) | 34 | 44 | 47 | 51 | 70 |
| E (MT) | 0 | 16 | 22 | 30 | 60 |
| F (MT) | 234 | 234 | 234 | 234 | 234 |

Beispiel 2: Herstellung von Formstoffen in Form von Prüfkörpern

Lagerstabile Formmassen entsprechend Beispiel 1 werden nach üblichen Transferpreßverfahren zu Prüfkörpern verarbeitet (Preßtemperatur: 175 °C; Preßdruck: 100 bar; Preßdauer: 4 min). Die Messung der thermisch-mechanischen Eigenschaften und des Brandverhaltens der Prufkorper, die nach üblichen DIN-Methoden erfolgt, erbringt die in Tabelle 2 zusammengestellten Ergebnisse.

Um mit dem Stand der Technik vergleichen zu können, wurde in einem weiteren Versuch das Polyamin durch den technisch bislang am meisten verwendeten Härter Dicyandiamid ersetzt. Dazu wurden 60 Masseteile Phenyl-diglycidyl-phosphonat mit einer Lösung von 9 Masseteilen Dicyandiamid in 15 Masseteilen Dimethylformamid und mit 0,9 Masseteilen Dimethylbenzylamin versetzt. Die dabei erhaltene Lösung wurde mit 163 Masseteilen Quarzgutmehl, beispielsweise Silbond FW 12 EST, vermischt und - wie in Beispiel 1a beschrieben - zu einer rieselfähigen Masse aufbereitet. Beim Verpressen wurde festgestellt, daß diese Masse bei 175 °C selbst nach 45 min nicht formstabil wird. Auch nach 120 min bei 180 °C wurde keine ausreichende Härtung erhalten. Auf eine weitere Beurteilung dieses Systems wurde deshalb verzichtet.

Tabelle 2

| Versuchs-Nr. | 1 | 2 | 3 | 4 | 5 |
|---|---|---|---|---|---|
| Meßwerte nach Preßvorgang: | | | | | |
| Glasübergangstemperatur $T_G$ (°C) | 210 | 215 | 215 | 220 | 220 |
| Biegefestigkeit (N/mm²) | 168±17 | 152±14 | 147±12 | 146±12 | 146±12 |
| Schlagzähigkeit (Nmm/mm²) | 5,7±1,4 | 5,5±1,2 | 5,3±1,0 | 5,1±1,0 | 5,1±1,0 |
| Meßwerte nach Härtung*): | | | | | |
| $T_G$ (°C) | 245 | 255 | 260 | 260 | 260 |
| Biegefestigkeit (N/mm²) | 134±20 | 138±20 | 143±18 | 144±15 | 146±12 |
| Schlagzähigkeit (Nmm/mm²) | 6,2±1,1 | 5,8±1,0 | 4,8±0,8 | 4,9±1,0 | 5,0±1,0 |
| mittlere Brenndauer nach UL 94V: | | | | | |
| von 1 mm-Proben (s) | > 40 | 4,2 | 3,5 | 2,0 | < 1 |
| von 3 mm-Proben (s) | > 40 | 1,8 | 1,6 | < 1 | 0 |
| Einstufung | nicht möglich | V-0 | V-0 | V-0 | V-0 |

*) 2 h bei 190°C und 2 h bei 210°C

Beispiel 3

42 Masseteile eines epoxidierten Novolaks (mit einem Epoxidwert von 0,57), 17 Masseteile Triglycidylphosphat und 37 Masseteile eines entsprechend Beispiel 1a hergestellten Polyamins (mit einem $NH_2$-Wert

von 8,7 %) werden, wie in Beispiel 1b beschrieben, mit 224 Masseteilen Quarzgutmehl, beispielsweise Silbond FW 12 EST, trocken gemischt und zur Beurteilung der thermischmechanischen Eigenschaften und des Brandverhaltens zu den nach den DIN-Vorschriften erforderlichen Prüfkörpern verpreßt (Preßtemperatur: 175 °C, Preßdruck 100 bar, Preßdauer 4 min). Direkt nach dem Preßvorgang werden folgende Werte gemessen: $T_G$ = 240 °C, Biegefestigkeit: 139 ± 13 N/mm$^2$, Schlagzähigkeit: 5,6 ± 0,2 Nmm/mm$^2$. Nach zweistündigem Härten bei 190 °C und weiteren 2 h bei 210 °C wird - bei nahezu unveränderter Schlagzähigkeit und Biegefestigkeit - eine $T_G$ von 270 °C gefunden. Diese Werte belegen die Möglichkeit einer sehr kurzen Zykluszeit beim Verpressen der Formmassen. An 3 mm-Stäben wird nach UL 94V eine mittlere Nachbrenndauer von 3 s gefunden, was einer V-O-Einstufung entspricht.

Beispiel 4

Die in Tabelle 3 angegebenen Mengen eines epoxidierten Novolaks (mit einem Epoxidwert von 0,57), eines entsprechend Beispiel 1a hergestellten Polyamins (mit einem $NH_2$-Wert von 8,7 %), einer Glycidylgruppen-haltigen Phosphorverbindung und von Quarzgutmehl, beispielsweise Silbond FW 12 EST, werden, wie in Beispiel 1b beschrieben, auf einem Walzenstuhl gemischt. Die dabei erhaltenen lagerstabilen Formmassen werden, wie in Beispiel 2 beschrieben, zu Prüfkörpern verarbeitet. Tabelle 3 enthält die an diesen Prüfkörpern gemessene Glasübergangstemperatur $T_G$ und die an 1 mm dicken Prüfkörpern ermittelte mittlere Brenndauer nach UL 94V.

Tabelle 3

| Versuchs-Nr. | 6 | 7 | 8 | 9 | 10 | 11 |
|---|---|---|---|---|---|---|
| Komponenten: | | | | | | |
| epoxidierter Novolak (MT) | 175 | 175 | 175 | 175 | 175 | 175 |
| Polyamin (MT) | 183 | 183 | 183 | 183 | 183 | 183 |
| Methyl-diglycidyl-phosphonat[1)] (MT) | 104 | - | - | - | - | - |
| Ethyl-diglycidyl-phosphonat[1)] (MT) | - | 111 | - | - | - | - |
| Methyl-diglycidyl-phosphat[2)] (MT) | - | - | 112 | - | - | - |
| Ethyl-diglycidyl-phosphat[2)] (MT) | - | - | - | 119 | - | - |
| Phenyl-diglycidyl-phosphat[2)] (MT) | - | - | - | - | 143 | - |
| p-Methoxyphenyl-diglycidyl-phosphat[2)] (MT) | - | - | - | - | - | 158 |
| Quarzgutmehl (MT) | 1078 | 1094 | 1096 | 1113 | 1169 | 1204 |
| Meßwerte nach Pressen[*)] und Nachhärten[**)]: | | | | | | |
| Glasübergangstemperatur $T_G$ (°C) | 270 | 270 | 260 | 260 | 270 | 260 |
| mittlere Brenndauer nach UL 94V (s) | 2,5 | 4,0 | 2,0 | 3,1 | $<$ 1 | 2,0 |
| Einstufung | V-0 | V-0 | V-0 | V-0 | V-0 | V-0 |

1) siehe: "Zh. Obshch. Khim." 54 (10), 2404 (1984) bzw. C.A. 102 (19), 166845d

2) siehe: "Isv. Akad. Nauk. SSSR", Ser. Khim. (9), 2006 (1967) bzw. C.A. 68 (7), 29789d

*) 4 min bei 175°C

**) 2 . bei 190°C und 2 h bei 210°C

## Beispiel 5

Die in Tabelle 4 angegebenen Mengen eines Epoxidharzes, eines Polyamins entsprechend Beispiel 1a ($NH_2$-Wert: 8,7 %), von Phenyl-diglycidyl-phosphonat und von Quarzgutmehl, beispielsweise Silbond FW 12

EST, werden, wie in Beispiel 1b beschrieben, auf einem Walzenstuhl gemischt. Die dabei erhaltenen lagerstabilen Formmassen werden, wie in Beispiel 2 beschrieben, zu Prüfkörpern verarbeitet. Tabelle 4 enthält die an diesen Prüfkörpern gemessene Glasübergangstemperatur $T_G$ und die an 1 mm dicken Probekörpern ermittelte mittlere Brenndauer nach UL 94V.

Tabelle 4

| Versuchs-Nr. | 12 | 13 | 14 | 15 | 16 |
|---|---|---|---|---|---|
| Komponenten: | | | | | |
| epoxidierter Novolak[1)] (MT) | 185 | 93 | - | - | - |
| oxazolidinonmodifiziertes Epoxidharz[2)] (MT) | - | 238 | - | - | - |
| Bisphenol-A-diglycidylether[3)] (MT) | - | - | 175 | - | - |
| Bisphenol-F-diglycidylether[4)] (MT) | - | - | - | 164 | - |
| Hydantoin-Epoxidharz[5)] (MT) | - | - | - | - | 175 |
| Polyamin (MT) | 183 | 183 | 183 | 183 | 183 |
| Phenyl-diglycidyl-phosphonat (MT) | 135 | 135 | 135 | 135 | 135 |
| Quarzgutmehl (MT) | 1174 | 1514 | 1150 | 1125 | 1150 |
| Meßwerte nach Pressen[*)] und Nachhärten[**)]: | | | | | |
| Glasübergangstemperatur $T_G$ (°C) | 275 | 215 | 260 | 255 | 270 |
| mittlere Brenndauer nach UL 94V (s) | 1,2 | 4,2 | 2,2 | 1,5 | 3,0 |
| Einstufung | V-0 | V-0 | V-0 | V-0 | V-0 |

1) Epoxidwert: 0,54; Viskosität bei 150°C: 600 cSt
2) Epoxidwert: 0,21
3) Epoxidwert: 0,57; Viskosität bei 25°C: 4000 bis 6000 mPa.s
4) Epoxidwert: 0,61; Viskosität bei 25°C: 1200 ± 100 mPa.s
5) Epoxidwert: 0,57; Viskosität bei 80°C: 9000 mPa.s
*) 4 min bei 175°C
**) 2 h bei 190°C und 2 h bei 210°C

## Patentansprüche

1. Epoxidharz-Formmassen zur Umhüllung von Halbleiterbauelementen, **dadurch gekennzeichnet,** daß sie folgende Komponenten enthalten:

   (A) ein phosphorfreies aromatisches und/oder heterocyclisches Polyepoxidharz, gegebenenfalls in Abmischung mit einem aliphatischen Epoxidharz,

   (B) eine epoxidgruppenhaltige Phosphorverbindung folgender Struktur:

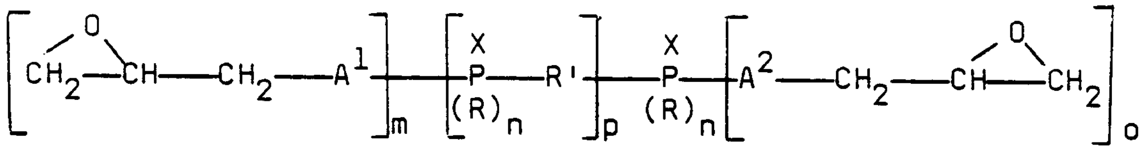

   mit m = 0 oder 1, n = 0, 1 oder 2 und o = 1, 2 oder 3, wobei folgendes gilt: m + n + o = 3, und mit p = 0, 1 oder 2;

   | | |
   |---|---|
   | X | bedeutet ein freies Elektronenpaar oder ein über eine Doppelbindung gebundenes O- oder S-Atom, |
   | R | bedeutet einen direkt oder über O oder S gebundenen Alkylrest mit 1 bis 4 C-Atomen, Alkenylrest mit 2 bis 3 C-Atomen, Arylrest, Aralkylrest, Dialkylamino- oder Alkylarylaminorest oder 3-Trialkylsilyl-propylrest, |
   | R' | bedeutet eine Brücke aus O, S, Phenylen, Dioxyphenylen, Dioxynaphthylen, $(CH_2)_r$, $O-(CH_2)_r$, $O-(CH_2)_r-O$ oder $O-(CH_2)_r-(Si(CH_3)_2-O)_s-Si(CH_3)_2(CH_2)_r-O$ mit r = 1 bis 3 und s = 1 bis 8, oder $(O-CH_2-CH_2)_t-O$, $(O-CH(CH_3)-CH_2)_t-O$oder $(O-(CH_2)_4)_t-O$ mit t = 2 bis 100, und |
   | $A^1$ und $A^2$, | die gleich oder verschieden sein können, bedeuten eine Einfachbindung oder eine Brücke entsprechend der Gruppierung R'; |

   (C) ein aromatisches Polyamin folgender Struktur als Härter:

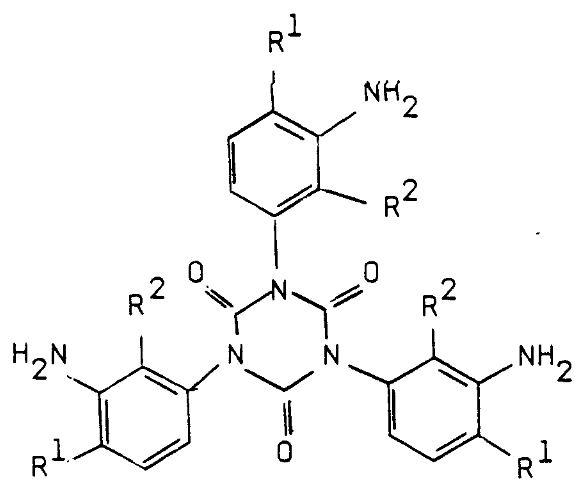

,

   wobei an jeder der drei aromatischen Partialstrukturen jeweils einer der Reste $R^1$ und $R^2$ H und der andere Alkyl bedeutet; und

   (D) Füllstoffe.

2. Epoxidharz-Formmassen nach Anspruch 1, **dadurch gekennzeichnet,** daß die Komponente (B) ein Di- oder Triglycidylester der Phosphorsäure oder ein Gemisch dieser Verbindungen ist.

3. Epoxidharz-Formmassen nach Anspruch 1, **dadurch gekennzeichnet,** daß die Komponente (B) ein Diglycidylester einer Alkyl- oder Arylphosphonsäure ist.

4. Epoxidharz-Formmassen nach Anspruch 1, **dadurch gekennzeichnet,** daß die Komponente (B) ein Di- oder Triglycidylester der phosphorigen Säure oder ein Gemisch dieser Verbindungen ist.

5. Epoxidharz-Formmassen nach einem der Ansprüche 1 bis 4, **dadurch gekennzeichnet,** daß das Verhältnis der Komponente (A) zur Komponente (B) 10:1 bis 1:10 beträgt, vorzugsweise 4:1 bis 1:4.

6. Epoxidharz-Formmassen nach einem oder mehreren der Ansprüche bis 5, **dadurch gekennzeichnet,** daß das Verhältnis zwischen Epoxid-Funktion und Aminwasserstoff-Funktion 0,9:1 bis 1,1:1 beträgt, vorzugsweise etwa 1:1.

7. Epoxidharz-Formmassen nach einem oder mehreren der Ansprüche 1 bis 6, **dadurch gekennzeichnet,** daß die Komponente (C) ein Gemisch von Polyaminen ist, hergestellt durch Trimerisierung eines Gemisches aus 2.4- und 2.6-Diisocyanato-alkylbenzolen und nachfolgende Hydrolyse.

8. Epoxidharz-Formmassen nach einem oder mehreren der Ansprüche 1 bis 7, **dadurch gekennzeichnet,** daß die Komponente (C) im Gemisch mit weiteren aromatischen und/oder heterocyclischen Polyaminen als Härter vorliegt.

9. Epoxidharz-Formmassen nach Anspruch 8, **dadurch gekennzeichnet,** daß der Anteil der Komponente (C) im Härtergemisch wenigstens 70 Masse-% beträgt.

10. Epoxidharz-Formmassen nach einem oder mehreren der Ansprüche 1 bis 9, **dadurch gekennzeichnet,** daß das Polyepoxidharz ein epoxidierter Novolak ist.

11. Epoxidharz-Formmassen nach einem oder mehreren der Ansprüche 1 bis 10, **dadurch gekennzeichnet,** daß die Füllstoffe pulverförmige anorganische und/oder organische Stoffe sind, gegebenenfalls im Gemisch mit anorganischen und/oder organischen Kurzfasern.

12. Epoxidharz-Formmassen nach Anspruch 11, **dadurch gekennzeichnet,** daß der Füllstoff $\alpha$-strahlungsarmes Quarzgutmehl ist.

13. Epoxidharz-Formmassen nach einem oder mehreren der Ansprüche 1 bis 12, **dadurch gekennzeichnet,** daß der Füllstoffanteil 50 bis 85 Masse-% beträgt, vorzugsweise 60 bis 80 Masse-%.

14. Epoxidharz-Formstoffe, hergestellt aus Epoxidharz-Formmassen nach einem oder mehreren der Ansprüche 1 bis 13.

## Claims

1. Epoxide resin moulding materials for covering semiconductor structural elements,
characterized in that they contain the following components:
(A) a phosphorus-free aromatic and/or heterocyclic polyepoxide resin, optionally mixed with an aliphatic epoxide resin,
(B) a phosphorus compound, containing epoxide groups, of the following structure:

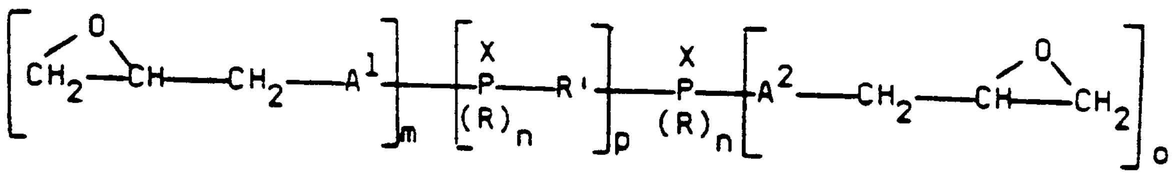

where m = 0 or 1, n = 0, 1 or 2 and o = 1, 2 or 3, whereby the following applies: m + n + o = 3, and where p = 0, 1 or 2;

| | |
|---|---|
| X | signifies a free electron pair or an O-atom or S-atom bonded by way of a double bond, |
| R | signifies an alkyl residue with 1 to 4 C-atoms, alkenyl residue with 2 to 3 C-atoms, aryl residue, arylalkyl residue, dialkylamino residue or alkylarylamino residue or 3- |

trialkylsilylpropyl residue, bonded directly or by way of O or S,

R' signifies a bridge of O, S, phenylene, dioxyphenylene, dioxynaphthylene, $(CH_2)r$, $O-(CH_2)_r$, $O-(CH_2)_r-O$ or $O-(CH_2)_r-(Si(CH_3)_2-O)_s-Si(CH_3)_2-(CH_2)_r-O$ where r = 1 to 3 and s = 1 to 8, or $(O-CH_2-CH_2)_t-O$, $(O-CH(CH_3)-CH_2)_t-O$or $(O-(CH_2)_4)_t-O$ where t = 2 to 100, and

$A^1$ and $A^2$, which can be the same or different, signify a single bond or a bridge according to the grouping R';

(C) an aromatic polyamine of the following structure as curing agent:

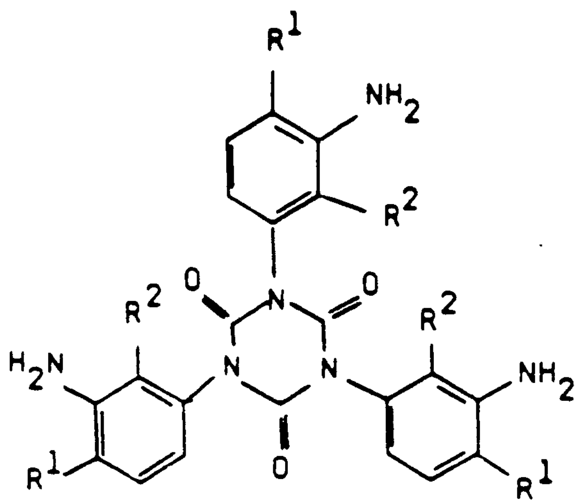

whereby at each of the three aromatic partial structures in each case one of the residues $R^1$ and $R^2$ signifies H and the other alkyl; and

(D) filler materials.

2. Epoxide resin moulding materials according to claim 1, characterized in that the component (B) is a diglycidyl ester or triglycidyl ester of phosphoric acid or a mixture of these compounds.

3. Epoxide resin moulding materials according to claim 1, characterized in that the component (B) is a diglycidyl ester of an alkyl or aryl phosphonic acid.

4. Epoxide resin moulding materials according to claim 1, characterized in that the component (B) is a diglycidyl ester or triglycidyl ester of phosphorous acid or a mixture of these compounds.

5. Epoxide resin moulding materials according to one of claims 1 to 4, characterized in that the ratio of the component (A) to the component (B) is 10:1 to 1:10, preferably 4:1 to 1:4.

6. Epoxide resin moulding materials according to one or more of claims 1 to 5, characterized in that the ratio between epoxide function and amine hydrogen function is 0.9:1 to 1.1:1, preferably about 1:1.

7. Epoxide resin moulding materials according to one or more of claims 1 to 6, characterized in that the component (C) is a mixture of polyamines, produced by trimerization of a mixture of 2,4- and 2,6-diisocyanato-alkylbenzenes and subsequent hydrolysis.

8. Epoxide resin moulding materials according to one or more of claims 1 to 7, characterized in that the component (C) is present in the mixture with further aromatic and/or heterocyclic polyamines as a curing agent.

9. Epoxide resin moulding materials according to claim 8, characterized in that the portion of the component (C) in the curing-agent mixture is at least 70 % by mass.

**10.** Epoxide resin moulding materials according to one or more of claims 1 to 9, characterized in that the Polyepoxide resin is an epoxidized novolak.

**11.** Epoxide resin moulding materials according to one or more of claims 1 to 10, characterized in that the filler materials are powdery inorganic and/or organic substances, optionally mixed with inorganic and/or organic short fibres.

**12.** Epoxide resin moulding materials according to claim 11 characterized in that the filler material is fused quartz powder low in $\alpha$-radiation.

**13.** Epoxide resin moulding materials according to one or more of claims 1 to 12, characterized in that the portion of filler material amounts to 50 to 85 % by mass, preferably 60 to 80 % by mass.

**14.** Epoxide resin moulded materials, produced from epoxide resin moulding materials according to one or more of claims 1 to 13.

**Revendications**

**1.** Composition à mouler à base de résine époxyde pour enrober des composants à semiconducteurs, caractérisée en ce qu'elle comporte les constituants suivants :

(A) une résine de polyépoxyde aromatique et/ou hétérocyclique exempte de phosphore, le cas échéant, en mélange avec une résine époxyde aliphatique,

(B) un composé phosphoré contenant des groupes époxydes et ayant la structure suivante

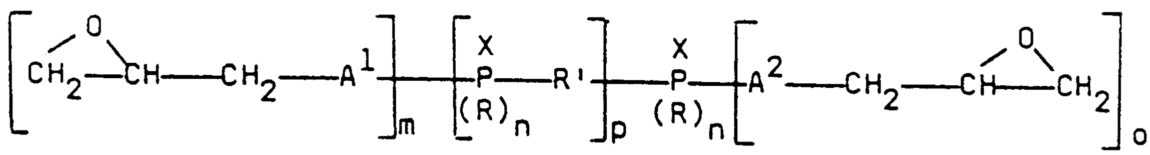

avec m = 0 ou 1, n = 0, 1 ou 2 et o = 1, 2 ou 3, et satisfaisant aux relations : m + n + o = 3, et avec p = 0, 1 ou 2;

| | |
|---|---|
| X | signifie une paire d'électrons libres ou un atome d'oxygène ou un atome de soufre relié par une double liaison, |
| R | signifie un radical alcoyle ayant de 1 à 4 atomes de carbone, un radical alcényle ayant de 2 à 3 atomes de carbone, un radical aryle, un radical aralcoyle, un radical dialcoylamino ou alcoylarylamino ou un radical 3-trialcoylsilylpropyle lié directement ou par l'intermédiaire de O ou de S, |
| R' | signifie un pont constitué de O, de S, de phénylène, de dioxyphénylène, de dioxynaphtylène, de $(CH_2)_r$, de $O-(CH_2)_r$, de $O-(CH_2)_r-O$ ou de $O-(CH_2)_r-(Si(CH_3)_2-O)_s-Si(CH_3)_2-(CH_2)_r-O$ avec r = 1 à 3 et s = 1 à 8, ou de $(O-CH_2-CH_2)_t-O$, de $(O-CH(CH_3)-CH_2)_t-O$ ou de $(O-(CH_2)_4)_t-O$ avec t = 2 à 100, et |
| $A^1$ et $A^2$, | qui peuvent être identiques ou différents, signifient une simple liaison ou un pont correspondant au groupement R'; |

(C) une polyamine aromatique ayant la structure suivante comme durcisseur :

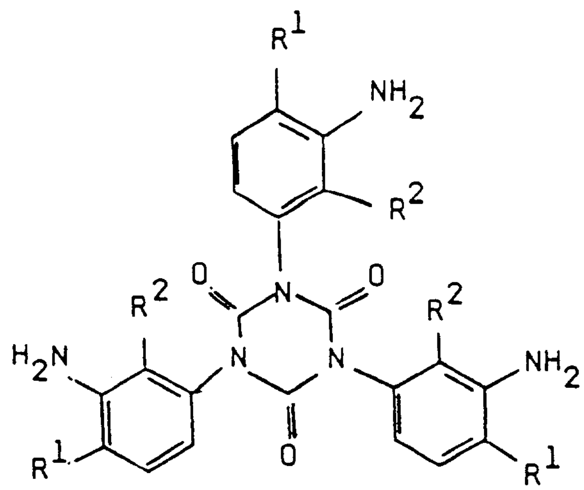

,

l'un des radicaux $R^1$ et $R^2$ de chacune des trois structures aromatiques partielles étant H et l'autre étant alcoyle, et
(D) des charges.

**2.** Composition à mouler à base de résine époxyde suivant la revendication 1, caractérisée en ce que le constituant (B) est un ester diglycidylique ou un ester triglycidylique de l'acide phosphorique ou un mélange de ces composés.

**3.** Composition à mouler à base de résine époxyde suivant la revendication 1, caractérisée en ce que le constituant (B) est un ester diglycidylique d'un acide alcoylphosphonique ou d'un acide arylphosphonique.

**4.** Composition à mouler à base de résine époxyde suivant la revendication 1, caractérisée en ce que le constituant (B) est un ester diglycidylique ou un ester triglycidylique de l'acide phosphoreux ou un mélange de ces composés.

**5.** Composition à mouler à base de résine époxyde suivant l'une des revendications 1 à 4, caractérisée en ce que le rapport du constituant (A) au constituant (B) est compris entre 10:1 et 1:10 et, de préférence, entre 4:1 et 1:4.

**6.** Composition à mouler à base de résine époxyde suivant l'une ou plusieurs des revendications 1 à 5, caractérisée en ce que le rapport entre la fonction époxyde et la fonction hydrogène d'amine est compris entre 0,9:1 et 1,1:1 et, de préférence, est de 1:1 environ.

**7.** Composition à mouler à base de résine époxyde suivant l'une ou plusieurs des revendications 1 à 6, caractérisée en ce que le constituant (C) est un mélange de polyamines, préparé par trimérisation d'un mélange de 2,4-diisocyanato-alcoylbenzène et de 2,6-diisocyanato-alcoylbenzène, suivie d'une hydrolyse.

**8.** Composition à mouler à base de résine époxyde suivant l'une ou plusieurs des revendications 1 à 7, caractérisée en ce que le constituant (C) est mélangé à d'autres polyamines aromatiques et/ou hétérocycliques servant de durcisseur.

**9.** Composition à mouler à base de résine époxyde suivant la revendication 8, caractérisée en ce que la proportion du constituant (C) dans le mélange durcisseur représente au moins 70 % en poids.

**10.** Composition à mouler à base de résine époxyde suivant l'une ou plusieurs des revendications 1 à 9, caractérisée en ce que la résine de polyépoxyde est une Novolaque époxydée.

11. Composition à mouler à base de résine époxyde suivant l'une ou plusieurs des revendications 1 à 10, caractérisée en ce que les charges sont des substances pulvérulentes minérales et/ou organiques, le cas échéant, mélangées à des libres courtes minérales et/ou organiques.

12. Composition à mouler à base de résine époxyde suivant la revendication 11, caractérisée en ce que la charge est de la poudre de silice fondue émettant peu de rayons $\alpha$.

13. Composition à mouler à base de résine époxyde suivant l'une ou plusieurs des revendications 1 à 12, caractérisée en ce que la proportion de charges représente de 50 à 85 % en poids et, de préférence, de 60 à 80 % en poids.

14. Matière moulée à base de résine époxyde préparée à partir de compositions moulées à base de résine époxyde suivant l'une ou plusieurs des revendications 1 à 13.